# FASCICULE DE BREVET EUROPEEN

(11) **EP 1 196 994 B1**
(45) Date de publication et mention de la délivrance du brevet: **15.09.2010**
(21) Numéro de dépôt: 00945473.7
(22) Date de dépôt: 11.07.2000
(51) Int. Cl.: H03K 17/082

(54) **PROCEDE DE PROTECTION DES SEMI-CONDUCTEURS DE PUISSANCE D'UN CONVERTISSEUR DE PUISSANCE ET CONVERTISSEUR METTANT EN OEUVRE CE PROCEDE**
SCHUTZVERFAHREN FÜR LEISTUNGSHALBLEITER EINES LEISTUNGSWANDLERS UND DIESES VERWENDENDER WANDLER
METHOD FOR PROTECTING POWER SEMICONDUCTORS OF A POWER CONVERTER AND CONVERTER IMPLEMENTING SAME

(30) Priorité: 15.07.1999 EP 99870159
(43) Date de publication de la demande: 17.04.2002
(73) Titulaire: Alstom Belgium Transport, 6001 Charleroi (BE)
(72) Inventeur: MONNOM, Olivier, B-1435 Mont-Saint-Guibert (BE); BELLAVOINE, Jacques, B-4520 Vinalmont (BE); WEYTENS, Michel, B-1420 Braine l'Alleud (BE)
(74) Mandataire: Blot, Philippe Robert Emile
(86) Numéro de dépôt international: PCT/BE2000/000082
(87) Numéro de publication internationale: WO 2001/006654

(56) Documents cités:
- EP-A- 0 666 647
- US-A- 5 636 097
- PATENT ABSTRACTS OF JAPAN vol. 018, no. 480 (E-1603), 8 septembre 1994 (1994-09-08) & JP 06 163911 A (NIPPONDENSO CO LTD), 10 juin 1994 (1994-06-10) cité dans la demande

## Description

### Objet de l'invention

La présente invention concerne un procédé de protection des semi-conducteurs de puissance d'un convertisseur de puissance.

La présente invention se rapporte également au convertisseur mettant en oeuvre ce procédé.

### Arrière-plan technologique

En électronique de puissance, les systèmes de conversion électrique (convertisseurs DC-AC, AC-DC, DC-DC et AC-AC) utilisent des semi-conducteurs commandés faisant office d'interrupteurs électriques, tels que les transistors bipolaires, les thyristors, les GTO, les MOSFET, les IGBT, etc. Ces semi-conducteurs possèdent intrinsèquement une limitation quant à la tension maximale admissible à leurs bornes. Dans certaines circonstances, on souhaite commander l'interrupteur de manière à le rendre conducteur (en le fermant), au moins partiellement, pour éviter qu'une surtension naissante à ses bornes ne vienne à le détruire. C'est pour cette raison que divers circuits de protection ont été développés.

Cette préoccupation apparaît par exemple dans la conception des circuits d'alimentation des moteurs électriques à propulsion (synchrones, asynchrones, continus). Ceux-ci sont constitués de convertisseurs, comme par exemple les onduleurs triphasés associés à des hacheurs, où les semi-conducteurs utilisés en guise d'interrupteurs doivent présenter une tenue en tension au moins équivalente et de préférence valant plusieurs fois la tension caténaire continue nominale. En particulier, on choisit des semi-conducteurs pouvant résister à des surtensions de 2 à 3 fois la tension caténaire.

En particulier dans le cas des hautes tensions, c'est-à-dire des tensions caténaires continues nominales supérieures à 2000 V, il convient d'utiliser des semi-conducteurs présentant une tenue en tension maximale relativement élevée. En outre, ces semi-conducteurs doivent présenter un fonctionnement linéaire par opposition aux transistors de type "tout ou rien". Un choix judicieux de tels semi-conducteurs sont les IGBT, qui autorisent des tenues en tension maximales de plus en plus élevées et allant jusqu'à 6,5 kV.

Dans ce qui suit, on prend comme exemple des interrupteurs de type IGBT, car ceux-ci sont des interrupteurs qui peuvent résister à des tensions relativement élevées, et de toute manière supérieures à 2 kV, alors que les transistors de puissance bipolaires et les MOSFETs sont limités à une tension de maximum 1000 V environ.

En outre, les IGBT présentent des qualités intrinsèques de rapidité et de facilité de commande.

Toutefois, dans le cas où les tensions maximales sont plus faibles, il est habituel de disposer plusieurs interrupteurs (semi-conducteurs) en série. Il est dans ce cas obligatoire de leur associer un système d'écrêtage. Ceci est particulièrement vrai dans le cas des IGBT, qui autorisent une tenue en tension relativement faible (de l'ordre de 3,3 kV).

Le principe de fonctionnement d'un dispositif d'écrêtage actif est simple : on ferme l'interrupteur lorsque la tension à ses bornes dépasse une valeur prédéfinie. A cette fin, un dispositif à seuil de tension (diodes à avalanche Zener, Transil, etc.) est inséré entre une borne de puissance et la commande de l'interrupteur.

Le dispositif d'écrêtage actif est donc un dispositif qui sert à protéger l'IGBT contre des surtensions transitoires. Lorsqu'une surtension apparaît, le dispositif d'écrêtage entre en fonction en fermant l'IGBT qui va conduire alors dans sa zone linéaire. Le seuil de tension à partir duquel l'écrêtage entre en fonction est calculé pour que la tension aux bornes de l'IGBT n'atteigne jamais sa tension maximale admissible. Physiquement, le circuit écrêteur est disposé entre le collecteur et la grille d'un l'IGBT de manière à créer une boucle de réaction aussi rapide que possible.

Ce circuit à seuil de tension réinjecte un courant de commande lorsque la tension aux bornes de l'interrupteur dépasse une valeur prédéfinie (par exemple 2200 V). L'inconvénient est que ce dispositif abaisse le seuil maximal de tension admissible par l'interrupteur lorsque celui-ci ne conduit pas, c'est-à-dire dans le cas où l'interrupteur est ouvert pour un convertisseur à l'arrêt.

Lorsque la tension aux bornes de l'ensemble IGBT - dispositif d'écrêtage actif va dépasse 2,2 kV, il y aura allumage (fermeture) de l'interrupteur de puissance et la tension à ces bornes se maintiendra donc à environ 2,2 kV au lieu de 3,3 kV autorisés comme tension maximale admissible.

D'un point de vue statique, dans le cas d'un IGBT non commandé, donc d'un IGBT ouvert, la tension maximale que le circuit composé de l'IGBT et du dispositif d'écrêtage actif peut tenir est le seuil d'écrêtage qui est bien moindre que la tension maximale admissible de l'IGBT. Dans l'exemple ci-dessus, l'IGBT possède une tension maximale admissible de 3,3 kV et on lui adjoint un dispositif à écrêtage actif dont le seuil est de 2,2 kV : on obtient ainsi un dispositif qui à l'arrêt, est incontrôlable au-delà de 2,2 kV.

### Etat de la technique

Le document JP-06163911 décrit de manière très générale un dispositif qui permet de déterminer si le voltage du drain d'un MOSFET est supérieur au voltage d'une diode Zener reprise dans un circuit associé d'écrêtage. Il s'agit fort probablement d'un dispositif destiné à être utilisé dans des circuits intégrés présentant des voltages relativement faibles et de l'ordre de quelques dizaines de volts au grand maximum.

### Buts de l'invention

La présente invention vise à proposer un procédé de protection d'un convertisseur de puissance alimenté en haute tension, permettant aux interrupteurs de tenir la haute tension maximale admissible à leurs bornes lorsqu'ils sont ouverts, et ceci dans le cas où un système d'écrêtage est prévu.

### Principaux éléments caractéristiques de l'invention

La présente invention se rapporte à un procédé de protection d'un interrupteur de puissance présent dans un convertisseur de puissance, associé à un dispositif d'écrêtage à seuil de tension, selon lequel on assure le maintien de la tension maximale admissible aux bornes de l'interrupteur de puissance en inhibant la fonction d'écrêtage à seuil de tension lorsque l'interrupteur de puissance est éteint.

De préférence, on assure le maintien de la tension maximale admissible aux bornes de l'interrupteur de puissance à l'aide d'un interrupteur d'inhibition placé entre le dispositif d'écrêtage à seuil de tension et la commande de l'interrupteur de puissance.

Selon une forme d'exécution préférée, on utilise la même commande pour commander l'interrupteur d'inhibition et l'interrupteur de puissance.

Avantageusement, le flanc montant de l'impulsion de commande de l'interrupteur d'inhibition est synchronisé sur celui de l'impulsion de commande de l'interrupteur de puissance et le flanc descendant de l'impulsion de commande de l'interrupteur d'inhibition présente un retard sur celui de l'impulsion de l'interrupteur de puissance.. De préférence, ledit retard est compris entré 50 et 500 µs et est de préférence proche de 200 µs.

La présente invention se rapporte également à un convertisseur de puissance associé à un dispositif d'écrêtage comprenant au moins un interrupteur de puissance, une commande dudit interrupteur interrupteur d'inhibition placé entre le dispositif d'écrêtage à seuil de tension et la commande de l'interrupteur de puissance, **caractérisé en ce que** ladite commande permet de commander à la fois l'interrupteur de puissance et l'interrupteur d'inhibition.

Selon une forme d'exécution préférée, le convertisseur comprend plusieurs interrupteurs de puissance disposés en série, lesdits interrupteurs étant associées à un dispositif d'écrêtage à seuil de tension.

Avantageusement, le ou les interrupteurs de puissance sont des semi-conducteurs à régime linéaire à haute tension tels que des IGBT de puissance.

De préférence, l'interrupteur d'inhibition est placé en série avec le dispositif d'écrêtage, l'ensemble étant connecté entre le collecteur et la grille de l'IGBT de puissance.

Avantageusement, l'interrupteur d'inhibition est un semi-conducteur à régime linéaire, de préférence un IGBT, ou un semi-conducteur de type "tout ou rien".

Enfin, la présente invention se rapporte à l'utilisation du procédé et du convertisseur décrits ci-dessus pour la protection contre les surtensions pour des interrupteurs de puissance présents dans un circuit hacheur abaisseur de tension.

### Brèle description des dessins

La Figure 1 représente le schéma de principe d'un dispositif d'écrêtage actif ou à seuil de tension monté sur un interrupteur de puissance.

La Figure 2 représente le schéma de principe d'un dispositif à IGBT d'inhibition d'êcrêtage actif monté entre l'élément à seuil de tension et la commande de l'IGBT de puissance pour la mise en oeuvre du procédé selon l'invention.

La Figure 3 représente les formes d'onde de commande de l'IGBT de puissance et de l'IGBT d'écrêtage.

La Figure 4 représente le schéma de principe complet du circuit d'inhibition d'écrêtage.

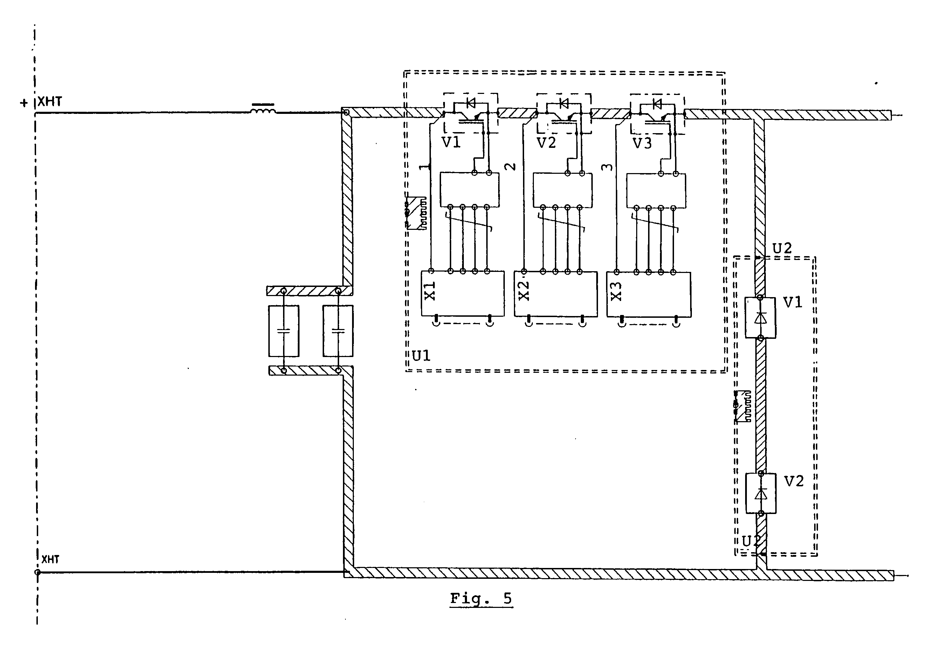

La Figure 5 représente le schéma de principe complet d'un circuit hacheur abaisseur de tension.

### Description détaillée de l'invention

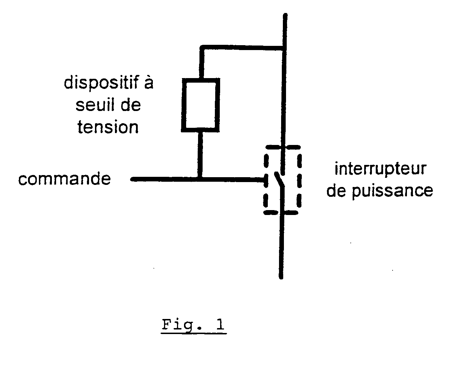

La Figure 1 montre le schéma de principe d'un interrupteur de puissance pourvu d'un dispositif à seuil de tension. Pour inhiber l'écrêtage actif, on insère un second interrupteur dans la boucle d'écrêtage. Cet interrupteur doit pouvoir supporter une forte tension et être rapide. Le choix d'un IGBT en petit boîtier est retenu pour satisfaire à ces critères. Il sera appelé dans la suite interrupteur ou IGBT d'inhibition.

La tension de l'IGBT d'inhibition doit être telle que le système ainsi formé puisse, en statique, récupérer tout ou partie de la tension maximale admissible de l'IGBT de puissance. Si l'on reprend l'exemple d'un IGBT qui a une tension maximale admissible de 3,3 kV et auquel est adjoint un dispositif d'écrêtage actif de 2,2 kV de seuil, la tension maximale admissible de l'IGBT d'inhibition doit valoir au moins 3,3 - 2,2 = 1,1 kV.

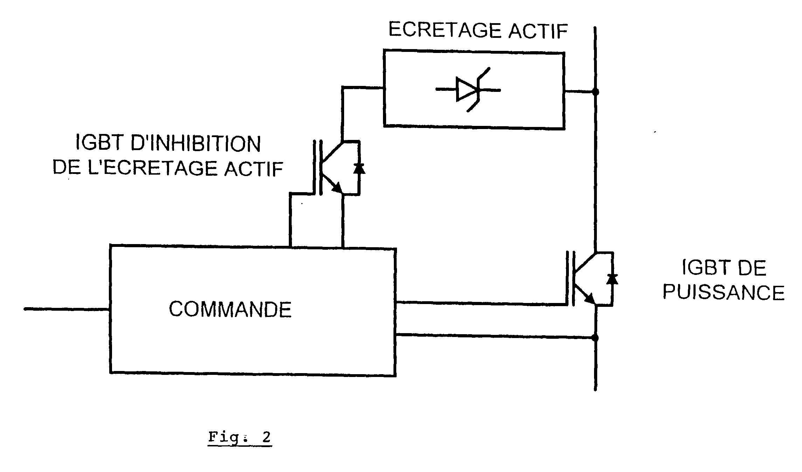

Parmi les nombreuses possibilités de commande de l'IGBT d'inhibition, on en a choisi une qui est dérivée des impulsions de commande de l'IGBT de puissance, ce qui permet de rendre transparent le fonctionnement de l'inhibition d'écrêtage vis à vis de l'électronique de commande. La stratégie de commande de l'IGBT d'inhibition est décrite à la Figure 2. Il faut veiller à ce que l'IGBT d'inhibition soit bien fermé avant l'instant où l'IGBT de puissance entre dans sa zone linéaire, que ce soit à l'allumage ou à l'extinction. Lorsque l'impulsion de commande de l'IGBT de puissance disparaît, on autorise encore l'écrêtage pendant 200 µs environ (Toff).

Le dispositif à écrêtage actif avec son circuit d'inhibition est applicable à tout système de conversion électrique susceptible de subir des surtensions de commutation (hacheur, onduleur, demi-pont redresseur, etc.).

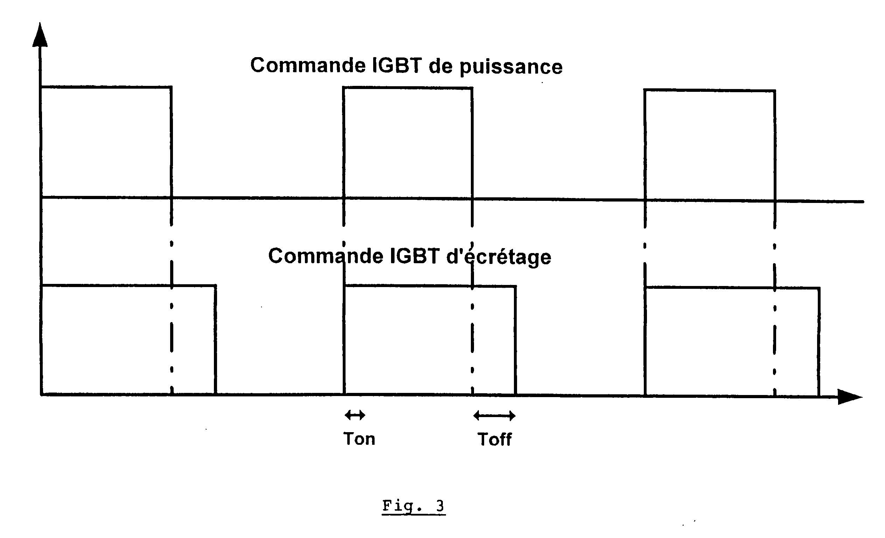

Le schéma complet du circuit d'inhibition d'écrêtage est représenté à la Figure 3, où V29 est l'IGBT d'inhibition, de tension maximale admissible 1,2 kV. Le circuit écrêteur, dont le seuil de tension est de 2,2 kV, est constitué de la diode V34, des résistances R11 et R2, des switchs X14 et X13, des diodes V22 à V1 et de la capacité C1.

Ce circuit reçoit les impulsions de l'IGBT de puissance via la connexion X20 ; il les transforme comme décrit à la Figure 2 et les applique à l'IGBT d'inhibition.

X18 est la connexion qui va à la grille de l'IGBT de puissance (via un circuit auxiliaire) tandis que X1 est relié à son collecteur.

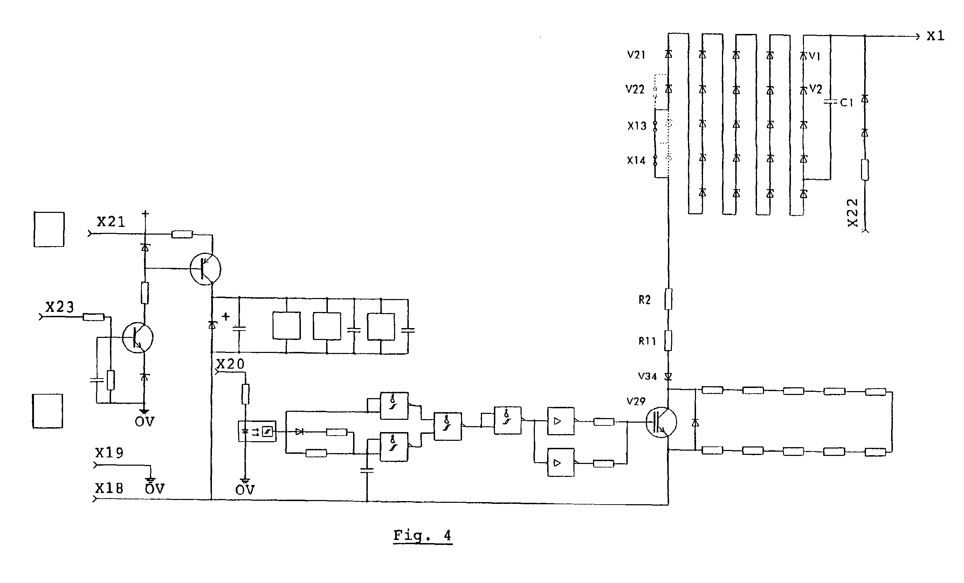

L'exemple particulier présenté ici utilise le dispositif dans le cadre d'une mise en série directe d'interrupteurs de puissance IGBT. La Figure 4 en montre le schéma d'application : il s'agit d'un hacheur dans lequel sont disposés 3 IGBT (U1 : V1, V2, V3) en série ainsi que deux diodes (U2 : V1, V2) en série. Grâce au dispositif d'inhibition d'écrêtage, la tension que peut supporter le hacheur est égale à 3 x la tension maximale admissible à chaque IGBT, soit 3 x 3,3 kV = 9,9 kV. Sans le dispositif d'inhibition d'écrêtage, la tension serait seulement de 3 x 2,2 kV = 6,6 kV, ce qui est insuffisant pour un réseau caténaire classique 3 kV.

## Revendications

1. Procédé de protection d'un interrupteur de puissance présent dans un convertisseur de puissance, associé à un dispositif d'écrêtage à seuil de tension, selon lequel on assure le maintien de la tension maximale admissible aux bornes de l'interrupteur de puissance en inhibant la fonction d'écrêtage à seuil de tension lorsque l'interrupteur de puissance est éteint.

2. Procédé selon la revendication 1, **caractérisé en ce que** l'on assure le maintien de la tension maximale admissible aux bornes de l'interrupteur de puissance à l'aide d'un interrupteur d'inhibition placé entre le dispositif d'êcrêtage à seuil de tension et la commande de l'interrupteur de puissance.

3. Procédé selon la revendication 1 ou 2, **caractérisé en ce que** l'on utilise la même commande pour commander l'interrupteur d'inhibition et l'interrupteur de puissance.

4. Procédé selon 1a revendication 3, **caractérisé en ce que** le flanc montant de l'impulsion de commande de l'interrupteur d'inhibition est synchronisé sur celui de l'impulsion de commande de l'interrupteur de puissance et **en ce que** le flanc descendant de l'impulsion de commande de l'interrupteur d'inhibition présente un retard sur celui de l'impulsion de l'interrupteur de puissance.

5. Procédé selon la revendication 4, **caractérisé en ce que** ledit retard est compris entre 50 et 500 µs, de préférence proche de 200 µs.

6. Convertisseur de puissance associé à un dispositif d'écrêtage comprenant :
- au moins un interrupteur de puissance,
- une commande dudit interrupteur de puissance,
- un interrupteur d'inhibition placé entre le dispositif d'écrêtage à seuil de tension et la commande de l'interrupteur de puissance, **caractérisé en ce que**
ladite commande permet de commander à la fois l'interrupteur de puissance et l'interrupteur d'inhibition pour inhiber la fonction d'écrêtage à seuil de tension lorsque l'interrupteur de puissance est éteint.

7. Convertisseur selon la revendication 6, **caractérisé en ce qu'**il comprend plusieurs interrupteurs de puissance disposés en série, lesdits interrupteurs étant associés à un dispositif d'écrêtage à seuil de tension.

8. Convertisseur selon la revendication 6 ou 7, **caractérisé en ce que** le ou les interrupteurs de puissance sont des semi-conducteurs à régime linéaire à haute tension tels que des IGBT de puissance.

9. Convertisseur selon la revendication 8, **caractérisé en ce que** l'interrupteur d'inhibition est placé en série avec le dispositif d'écrêtage, l'ensemble étant connecté entre le collecteur et la grille de l'IGBT de puissance.

10. Convertisseur selon l'une quelconque des revendications 6 à 9, **caractérisé en ce que** l'interrupteur d'inhibition est un semi-conducteur à régime linéaire, de préférence un IGBT, ou un semi-conducteur de type "tout ou rien".

11. Utilisation du procédé selon l'une quelconque des revendications 1 à 5 ou du convertisseur selon l'une quelconque des revendications 6 à 11 pour la protection contre les surtensions pour des interrupteurs de puissance présents dans un circuit hacheur abaisseur de tensions.

## Claims

1. Method of protecting a power switch in a power converter, associated with a device for limiting threshold voltage, according to which the maximum admissible terminal voltage to the power switch is maintained by inhibiting the function of the limiting threshold voltage when the power switch is turned off.

2. Method according to claim 1, **characterised in that** the maximum admissible terminal voltage to the power switch is maintained with the aid of an inhibiting switch located between the device for limiting threshold voltage and the controller of the power switch.

3. Method according to claim 1 or 2, **characterised in that** the same controller is used to control the inhibiting switch and the power switch.

4. Method according to claim 3, **characterised in that** the rising edge of the control pulse of the inhibiting switch is synchronised with that of the control pulse of the power switch and **in that** the trailing edge of the control pulse of the inhibiting switch has a delay relative to the pulse of the power switch.

5. Method according to claim 4, **characterised in that** the said delay is between 50 and 500 µs, preferably about 200 µs.

6. Power converter associated with a limiting device comprising:
- at least one power switch,
- a controller for the said power switch,
- an inhibiting switch located between the device for limiting threshold voltage and the controller of the power switch,
**characterised in that** the said controller allows the control at the same time of the power switch and the inhibiting switch to inhibit the function of the limiting threshold voltage when the power switch is turned off.

7. Converter according to claim 6, **characterised in that** it comprises several power switches disposed in series, the said switches being associated with one device for limiting threshold voltage.

8. Converter according to claim 6 or 7, **characterised in that** the or each power switch is a semi-conductor with linear characteristics at high voltage, such as a power IGBT.

9. Converter according to claim 8, **characterised in that** the inhibiting switch is placed in series with the limiting device, the assembly being connected between the collector and the gate of the power IGBT.

10. Converter according to any one of claims 6-9, **characterised in that** the inhibiting switch is a semi-conductor with linear characteristics, preferably an IGBT or a semi-conductor of the type "all or nothing".

11. Use of the method according to any one of claims 1-5 or of the converter according to any one of claims 6-11 for the protection against voltage surges for power switches in a step-down voltage chopper circuit.

## Patentansprüche

1. Verfahren zum Schutz eines Leistungsschalters in einem Leistungswandler, der einer Begrenzungsvorrichtung mit Spannungsschwelle zugeordnet ist, gemäß welchem man die Aufrechterhaltung der maximal zulässigen Spannung an den Klemmen des Leistungsschalters gewährleistet, indem man die Begrenzungsfunktion mit Spannungsschwelle hemmt, wenn der Leistungsschalter abgeschaltet ist.

2. Verfahren nach Anspruch 1, **dadurch gekennzeichnet, dass** man die Aufrechterhaltung der maximal zulässigen Spannung an den Klemmen des Leistungsschalters mit Hilfe eines Hemmschalters gewährleistet, der zwischen der Begrenzungsvorrichtung mit Spannungsschwelle und der Steuerung des Leistungsschalters angeordnet ist.

3. Verfahren nach Anspruch 1 oder 2, **dadurch gekennzeichnet, dass** man zum Steuern des Hemmschalters und des Leistungsschalters dieselbe Steuerung verwendet.

4. Verfahren nach Anspruch 3, **dadurch gekennzeichnet, dass** die Anstiegsflanke des Impulses zur Steuerung des Hemmschalters mit derjenigen des Impulses zur Steuerung des Leistungsschalters synchronisiert ist und dass die Abstiegsflanke des Impulses zur Steuerung des Hemmschalters eine Verzögerung gegenüber derjenigen des Impulses des Leistungsschalters aufweist.

5. Verfahren nach Anspruch 4, **dadurch gekennzeichnet, dass** die Verzögerung zwischen 50 und 500 µs beträgt, vorzugsweise nahe 200 µs.

6. Leistungswandler, der einer Begrenzungsvorrichtung zugeordnet ist, umfassend:
- mindestens einen Leistungsschalter,
- eine Steuerung des Leistungsschalters,
- einen Hemmschalter, der zwischen der Begrenzungsvorrichtung mit Spannungsschwelle und der Steuerung des Leistungsschalters angeordnet ist, **dadurch gekennzeichnet, dass**
die Steuerung es gestattet, gleichzeitig den Leistungsschalter und den Hemmschalter zu steuern, um die Begrenzungsfunktion mit Spannungsschwelle zu hemmen, wenn der Leistungsschalters abgeschaltet ist.

7. Wandler nach Anspruch 6, **dadurch gekennzeichnet, dass** er mehrere in Reihe angeordnete Leistungsschalter umfasst, wobei diese Schalter einer Begrenzungsvorrichtung mit Spannungsschwelle zugeordnet sind.

8. Wandler nach Anspruch 6 oder 7, **dadurch gekennzeichnet, dass** der oder die Leistungsschalter linear arbeitende Hochspannungshalbleiter wie Leistungs-IGBT's sind.

9. Wandler nach Anspruch 8, **dadurch gekennzeichnet, dass** der Hemmschalter mit der Begrenzungsvorrichtung in Reihe angeordnet ist, wobei diese Einheit zwischen den Kollektor und das Gitter des Leistungs-IGBT's geschaltet ist.

10. Wandler nach einem der Ansprüche 6 bis 9, **dadurch gekennzeichnet, dass** der Hemmschalter ein linear arbeitender Halbleiter, vorzugsweise ein IGBT, oder ein Halbleiter vom Typ "Ja-Nein" ist.

11. Verwendung des Verfahrens nach einem der Ansprüche 1 bis 5 oder des Wandlers nach einem der Ansprüche 6 bis 11 für den Schutz gegen Überspannungen für Leistungsschalter in einer spannungssenkenden Zerhackungsschaltung.
